# EUROPEAN PATENT SPECIFICATION

(11) **EP 2 618 373 B1**
(45) Date of publication and mention of the grant of the patent: **03.08.2016**
(21) Application number: 12151975.5
(22) Date of filing: 20.01.2012
(51) Int. Cl.: H05K 1/02, H01L 23/552, H05K 3/28, H01L 25/18

(54) **Mobile wireless communications device including conformable, shape-retaining vacuum formed film and related methods**
Tragbare drahtlose Kommunikationsvorrichtung, die einen anpassbaren, formbeständigen vakuumgeformten Film enthält, und verwandte Verfahren
Dispositif de communication sans fil mobile incluant un film formé sous vide conformable à retenue de forme et procédés associés

(43) Date of publication of application: 24.07.2013
(73) Proprietor: BlackBerry Limited, Waterloo, ON N2K 0A7 (CA)
(72) Inventor: Li, Fan Tommy, Waterloo, Ontario N2L 3W8 (CA); Liu, Tong, Waterloo, Ontario N2L 3W8 (CA)
(74) Representative: Greenaway, Martin William

(56) References cited:
- EP-A1- 1 499 172
- WO-A2-2008/027888
- US-A1- 2003 193 113

## Description

### Technical Field

The present disclosure generally relates to the field of wireless communications systems, and, more particularly, to mobile wireless communications devices and related methods.

### Background

Mobile wireless communications systems continue to grow in popularity and have become an integral part of both personal and business communications. For example, cellular telephones allow users to place and receive voice calls almost anywhere they travel, while tablet personal computers allow mobile data communications almost anywhere. Moreover, as mobile communications technology, for example, cellular communications technology, has increased, so too has the functionality of cellular devices and the different types of devices available to users. For example, many cellular devices now incorporate personal digital assistant (PDA) features such as calendars, address books, task lists, etc. Moreover, such multi-function devices, including, for example, tablet personal computers, may also allow users to wirelessly send and receive electronic mail
(email) messages and access the Internet via a cellular network and/or a wireless local area network (WLAN), for example.

Even so, as the functionality of cellular communications devices continues to increase, so too does the demand for smaller devices which are easier and more convenient for users to carry. One challenge this poses for cellular device manufacturers is designing housings that cooperate with antennas to provide desired operating characteristics within the relatively limited amount of space available.

International Patent Publication No. 2008/027888 is directed to an electrical device comprising an electronic component mounted to a surface of a printed circuit board, a ground connection on said surface, and electromagnetic interference (EMI) shielding.

United States Patent Publication No. 2003/0193113 is directed to a system for encapsulating a substrate on a vehicle structure.

European Patent Publication No. 1499172 is directed to a method of shielding a circuit device, a circuit board on which an electronic component is mounted and which has a ground connection portion is provided.

Aspects of an invention are defined in the appended independent claims. Some optional features are defined in the dependent claims.

### Brief Description of the Drawings

FIG. 1 is a schematic block diagram of a mobile wireless communications device including a conformable, shape-retaining film in accordance with one example embodiment.
FIG. 2 is a cross-sectional view of a portion of the PCB of FIG. 1 including the conformable, shape-retaining film prior to being vacuum formed.
FIG. 3 is a cross-sectional view of the portion of the PCB of FIG. 2 including the conformable, shape-retaining film after being vacuum formed.
FIG. 4 is a cross-sectional view of a portion of the PCB including the conformable, shape-retaining film prior to being vacuum formed according to another embodiment.
FIG. 5 is a cross-sectional view of the portion of the PCB of FIG. 4 including the conformable, shape-retaining film after being vacuum formed.
FIG. 6 is schematic block diagram illustrating additional components that may be included in the mobile wireless communications device of FIG. 1.

### Detailed Description

The present description is made with reference to the accompanying drawings, in which various embodiments are shown. However, many different embodiments may be used, and thus the description should not be construed as limited to the embodiments set forth herein. Rather, these embodiments are provided so that this disclosure will be thorough and complete. Like numbers refer to like elements throughout, and prime notation is used to indicate similar elements or steps in alternative embodiments.

In accordance with one exemplary aspect, a mobile wireless communications device may include a portable housing, a printed circuit board (PCB) carried by the portable housing, and at least one electronic component carried by PCB and extending upwardly therefrom, for example. The mobile wireless communications device may also include a conformable, shape-retaining film being vacuum formed onto the at least one electronic component and comprising a peripheral edge secured to the PCB and a body portion conforming to the at least one electronic component.

The conformable, shape-retaining film may include an electrically conductive layer to provide Radio Frequency (RF) shielding. The electrically conductive layer may include aluminum. The conformable, shape-retaining film may further include a dielectric layer adjacent the electrically conductive layer.

The mobile wireless communications device may further include a frame coupled to the PCB around the circuitry and secured to the peripheral edge of the conformable, shape-retaining film, for example. The mobile wireless communications device may further include an adhesive material layer carried by the at least one electronic component. The conformable, shape-retaining film may have a vacuum port opening therein adjacent the adhesive material layer.

The mobile wireless communications device may further include at least one other electronic component beneath the shape-retaining film, for example. The mobile wireless communications device may further include a wireless transceiver carried by the PCB. An antenna may be coupled to the wireless transceiver, for example.

The at least one electronic component may include at least one integrated circuit (IC). The at least one electronic component may include a processor, for example.

Another exemplary aspect is directed to a shield frame assembly. A method aspect is directed to a method of making a mobile wireless communications device including a portable housing, a printed circuit board (PCB) carried by the portable housing, and at least one electronic component carried by the PCB and extending upwardly therefrom. The method may include vacuum forming a conformable, shape-retaining film onto the at least one electronic component. The conformable, shape-retaining film may have a peripheral edge secured to the PCB, and a body portion conforming to the at least one electronic component.

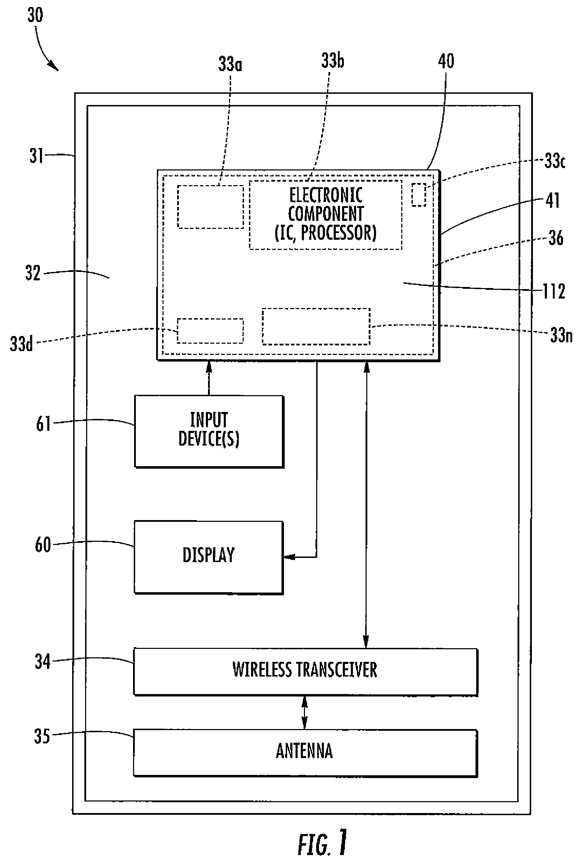

Referring now to FIGS. 1-3, a mobile wireless communications device **30** illustratively includes a portable housing **31** a printed circuit board (PCB) **32,** carried by the portable housing. The PCB **32** may also include a conductive layer defining a ground plane.

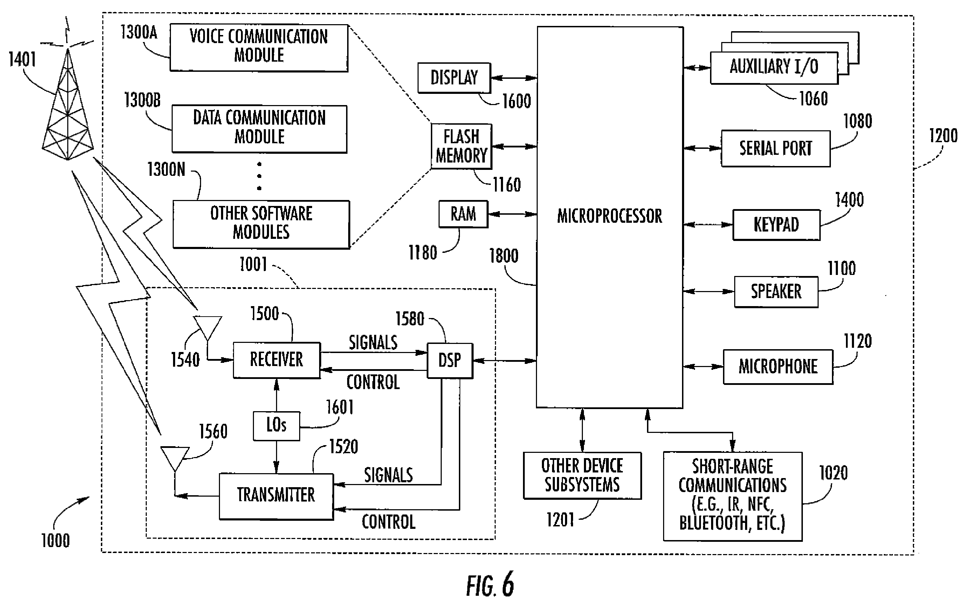

The exemplary device **30** further illustratively includes a display **60** and one or more input devices **61.** The input devices **61** may be in the form of a plurality of control keys including an "off hook" (i.e., initiate phone call) key, an "on hook" (i.e., discontinue phone call) key, a menu key, and a return or escape key. Operation of the various device components and input keys, etc., will be described further below with reference to FIG. 6.

The mobile wireless communications device **30** also includes electronic components **33a-33n** carried by the PCB **32** that extend updwardly therefrom. The electronic components **33a-33n** may include an integrated circuit, for example, a processor, or a memory. Other circuitry, for example, discrete components, associated with the mobile wireless communications device **30** may also be carried by the PCB **32.**

The mobile wireless communications device **30** also includes a wireless transceiver **34** and an antenna **35** coupled to the wireless transceiver. The wireless transceiver **34** may be configured to perform a wireless communications function, for example, wireless voice or data communications. The wireless transceiver **34** may be a cellular transceiver, for example.

The mobile wireless communications device **30** illustratively includes a frame **36** coupled to the PCB **32** around the electronic components **33a-33n.** The frame **36** may be metallic, for example, steel, aluminum, or other metal, as will be appreciated by those skilled in the art. In some embodiments, the frame **36** may include a pick-up tab that extends across the frame. The pick-up tab may used by assembly line machinery, for example, a vacuum, to pick-up the frame and place it on the PCB **32.** The pick-up tab may be removable after assembly, or may remain for additional support.

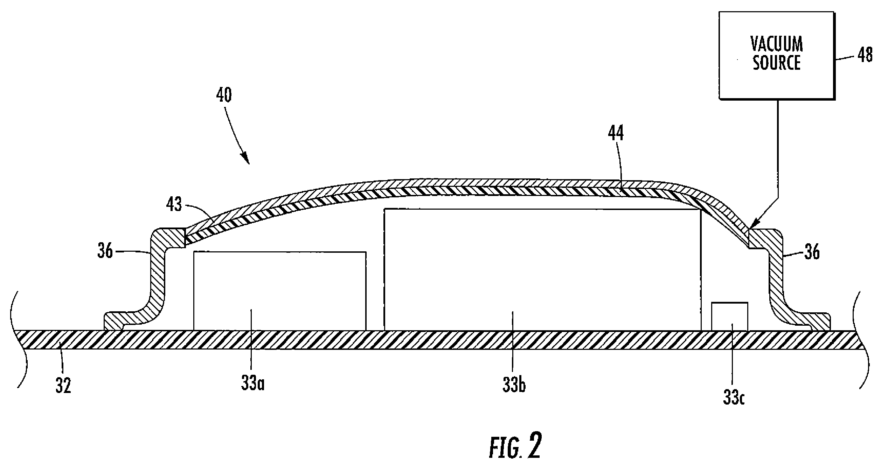

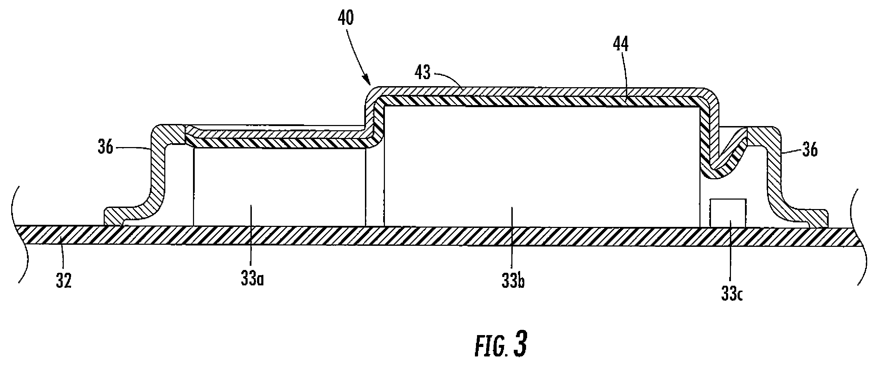

The mobile wireless communications device **30** also includes a conformable, shape-retaining film **40** that is positioned over the electronic components **33a-33n.** The conformable, shape-retaining film **40** retains its given shape, i.e., it is not elastic. The conformable, shape-retaining film **40** includes a peripheral edge **41** and a body portion **42** and includes two layers (FIGS. 2 and 3). The conformable, shape-retaining film **40** is positioned so that the peripheral edge **41** generally aligns with the frame **36** (FIG. 2).

More particularly, the conformable, shape-retaining film **40** includes an electrically conductive layer **43** that may advantageously provide radio frequency (RF) shielding, for example. The electrically conductive layer **43** may be aluminum, for example. Of course, the electrically conductive layer **43** may be another electrically conductive material.

The conformable, shape-retaining film **40** also illustratively includes a dielectric layer **44** adjacent the electrically conductive layer **43.** The dielectric layer **44** may be an inner layer with respect to the electrically conductive layer **43** such that it may physically contact one of the electronic components **33b.** The dielectric layer **44** may be a thermally conductive material, for example, graphite or a plastic, to increase thermal dissipation from the electronic components **33a-33n.** Of course, the dielectric layer **44** may be another thermally conductive material, or include one or more thermally conductive materials. The conformable, shape-retaining film **40** may include other or additional layers, as will be appreciated by those skilled in the art.

The conformable, shape-retaining film **40** is vacuum formed onto the electronic components **33a-33n** to conform thereto (FIG. 3). More particularly, the conformable, shape-retaining film **40** may be vacuum formed by securing a portion of the peripheral edge **41** of the conformable, shape-retaining film **40** to the frame **36,** and then applying a vacuum at another portion of the peripheral edge using a vacuum source **48** as would be appreciated by those skilled in the art. The application of the vacuum causes the conformable, shape-retaining film **40** to advantageously conform to the electronic components **33a-33n** and retain this conforming shape (FIG. 3). Other techniques and arrangements for coupling the conformable, shape-retaining film **40** to the frame **36** and applying a vacuum from the vacuum source **48** may be used as will be appreciated by those skilled in the art.

In some embodiments, the peripheral edge **41** may be directly coupled to the frame **36.** For example, the frame **36** may include a surface feature to facilitate coupling with peripheral edge **41** of the conformable, shape-retaining film **40.** Other features or techniques may be used to facilitate coupling of the frame **36** to the peripheral edge **41,** as will be appreciated by those skilled in the art.

In other embodiments, the frame **36** may be a two-part frame. A first frame part may be coupled to the conformable, shape-retaining film **40,** while a second frame part is coupled to the PCB **32** around the electronic components **33a-33n** as noted above.

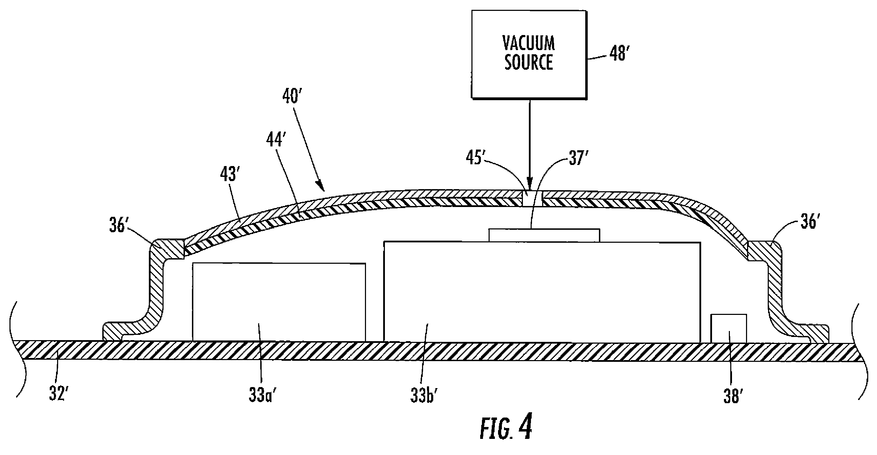

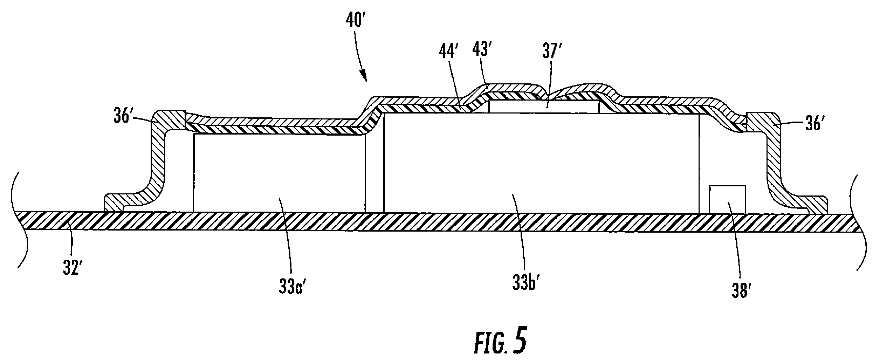

Referring now to FIGS. 4 and 5, in another embodiment, an adhesive material layer **37'** may be carried by one of the electronic components **33b'.** In particular, the adhesive layer **37'** may be carried by the electronic component that extends the most upwardly from the PCB **32'**, i.e., the tallest electronic component.

The conformable, shape-retaining film **40'** illustratively has a vacuum port opening **45'** therein adjacent the adhesive material layer **37'.** The conformable, shape-retaining film **40'** is positioned over the electronic components **33a'-33n'** with the peripheral edge **41'** aligned with the frame **36'.** A vacuum is applied at the vacuum port opening **45'** from the vacuum source **48'** so that the conformable, shape-retaining film **40'** conforms to the electronic components **33a'-33n'.** The vacuum causes the edges of the conformable, shape-retaining film **40'** at the vacuum port opening **45'** to contact the adhesive material layer **37'** and thus seal or close the vacuum port opening.

Additionally, as will be appreciated by those skilled in the art, another electronic component **38'** may be carried by the PCB **32'** underneath the conformable, shape-retaining film **40'.** In other words, the body portion **42'** of the conformable, shape-retaining film **40'** may not conform to another electronic component **38',** such as one lower in height. More than one other electronic component may be carried underneath the conformable, shape-retaining film **40'** so that the body portion **42'** does not contact or conform thereto.

The conformable, shape-retaining film **40** advantageously may operate similar to a heat sink, for example, to facilitate removal of heat from a processor, for example. As will be appreciated by those skilled in the art, the processor may generate an increased amount of heat compared to other electronic components. Moreover, the conformable, shape-retaining film **40** may also provide increased RF shielding of the electronic components **33a-33n** from other circuitry, for example, the wireless transceiver **34** and the antenna **35.**

Additionally, as will be appreciated by those skilled in the art, a conventional rigid RF shield, for example, may extend relatively high from the PCB and thus contribute to an increased overall thickness of the mobile wireless communications device. By being vacuum formed to conform to the electronic components **33a-33n,** the conformable, shape-retaining film **40** may allow the overall height or thickness of the mobile wireless communications device **30** may be reduced. In other words, an amount of space between the electronic components and the RF shield is reduced.

Additionally, the conformable, shape-retaining film **40** may also increasingly dissipate heat from the electronic components **33a-33n.** For example, a higher speed processor generally requires a more sufficient way to dissipate heat from the processor. The direct contact of the processor to the conformable, shape-retaining film **40** improves heat dissipation compared to air or a thermal gel filled space between a rigid shield and a processor, for example. The dielectric layer **44** and the electrically conductive layer **43,** as an RF shield, more efficiently, transfer an increased amount of heat generated by the processor to the surrounding area and the ground, as will be appreciated by those skilled in the art.

A method aspect is directed to a method of making a mobile wireless communications device **30** including a portable housing **31,** a printed circuit board **32** (PCB) carried by the portable housing, and at least one electronic component **33a-33n** carried by the PCB and extending upwardly therefrom. The method includes vacuum forming a conformable, shape-retaining film **40** onto the at least one electronic component **33a-33n.** The conformable, shape-retaining film **40** has a peripheral edge **41** secured to the PCB **32** and a body portion **42** conforming to the at least one electronic component **33a-33n.**

Example components of a mobile wireless communications device **1000** that may be used in accordance with the above-described embodiments are further described below with reference to FIG. 6. The device **1000** illustratively includes a housing **1200,** a keyboard or keypad **1400** and an output device **1600.** The output device shown is a display **1600,** which may comprise a full graphic LCD. Other types of output devices may alternatively be utilized. A processing device **1800** is contained within the housing **1200** and is coupled between the keypad **1400** and the display **1600.** The processing device **1800** controls the operation of the display **1600,** as well as the overall operation of the mobile device **1000,** in response to actuation of keys on the keypad **1400.**

The housing **1200** may be elongated vertically, or may take on other sizes and shapes (including clamshell housing structures). The keypad may include a mode selection key, or other hardware or software for switching between text entry and telephony entry.

In addition to the processing device **1800,** other parts of the mobile device **1000** are shown schematically in FIG. 6. These include a communications subsystem **1001;** a short-range communications subsystem **1020;** the keypad **1400** and the display **1600,** along with other input/output devices **1060, 1080, 1100** and **1120;** as well as memory devices **1160, 1180** and various other device subsystems **1201.** The mobile device **1000** may comprise a two-way RF communications device having data and, optionally, voice communications capabilities. In addition, the mobile device **1000** may have the capability to communicate with other computer systems via the Internet.

Operating system software executed by the processing device **1800** is stored in a persistent store, such as the flash memory **1160,** but may be stored in other types of memory devices, such as a read only memory (ROM) or similar storage element. In addition, system software, specific device applications, or parts thereof, may be temporarily loaded into a volatile store, such as the random access memory (RAM) **1180.** Communications signals received by the mobile device may also be stored in the RAM **1180.**

The processing device **1800,** in addition to its operating system functions, enables execution of software applications **1300A-1300N** on the device **1000.** A predetermined set of applications that control basic device operations, such as data and voice communications **1300A** and **1300B,** may be installed on the device **1000** during manufacture. In addition, a personal information manager (PIM) application may be installed during manufacture. The PIM may be capable of organizing and managing data items, such as e-mail, calendar events, voice mails, appointments, and task items. The PIM application may also be capable of sending and receiving data items via a wireless network **1401.** The PIM data items may be seamlessly integrated, synchronized and updated via the wireless network **1401** with corresponding data items stored or associated with a host computer system.

Communication functions, including data and voice communications, are performed through the communications subsystem **1001,** and possibly through the short-range communications subsystem. The communications subsystem **1001** includes a receiver **1500,** a transmitter **1520,** and one or more antennas **1540** and **1560.** In addition, the communications subsystem **1001** also includes a processing module, such as a digital signal processor (DSP) **1580,** and local oscillators (LOs) **1601.** The specific design and implementation of the communications subsystem **1001** is dependent upon the communications network in which the mobile device **1000** is intended to operate. For example, a mobile device **1000** may include a communications subsystem **1001** designed to operate with the Mobitex^{™}, Data TACT^{™} or General Packet Radio Service (GPRS) mobile data communications networks, and also designed to operate with any of a variety of voice communications networks, such as AMPS, TDMA, CDMA, WCDMA, PCS, GSM, EDGE, etc. Other types of data and voice networks, both separate and integrated, may also be utilized with the mobile device **1000.** The mobile device **1000** may also be compliant with other communications standards such as 3GSM, 3GPP, UMTS, 4G, etc.

Network access requirements vary depending upon the type of communication system. For example, in the Mobitex and DataTAC networks, mobile devices are registered on the network using a unique personal identification number or PIN associated with each device. In GPRS networks, however, network access is associated with a subscriber or user of a device. A GPRS device therefore typically involves use of a subscriber identity module, commonly referred to as a SIM card, in order to operate on a GPRS network.

When required network registration or activation procedures have been completed, the mobile device **1000** may send and receive communications signals over the communication network **1401.** Signals received from the communications network **1401** by the antenna **1540** are routed to the receiver **1500,** which provides for signal amplification, frequency down conversion, filtering, channel selection, etc., and may also provide analog to digital conversion. Analog-to-digital conversion of the received signal allows the DSP **1580** to perform more complex communications functions, such as demodulation and decoding. In a similar manner, signals to be transmitted to the network **1401** are processed (e.g. modulated and encoded) by the DSP **1580** and are then provided to the transmitter **1520** for digital to analog conversion, frequency up conversion, filtering, amplification and transmission to the communication network **1401** (or networks) via the antenna **1560.**

In addition to processing communications signals, the DSP **1580** provides for control of the receiver **1500** and the transmitter **1520.** For example, gains applied to communications signals in the receiver **1500** and transmitter **1520** may be adaptively controlled through automatic gain control algorithms implemented in the DSP **1580.**

In a data communications mode, a received signal, such as a text message or web page download, is processed by the communications subsystem 1001 and is input to the processing device **1800.** The received signal is then further processed by the processing device **1800** for an output to the display **1600,** or alternatively to some other auxiliary I/O device **1060.** A device may also be used to compose data items, such as e-mail messages, using the keypad **1400** and/or some other auxiliary I/O device **1060,** such as a touchpad, a rocker switch, a thumb-wheel, or some other type of input device. The composed data items may then be transmitted over the communications network **1401** via the communications subsystem **1001.**

In a voice communications mode, overall operation of the device is substantially similar to the data communications mode, except that received signals are output to a speaker **1100,** and signals for transmission are generated by a microphone **1120.** Alternative voice or audio I/O subsystems, such as a voice message recording subsystem, may also be implemented on the device **1000.** In addition, the display **1600** may also be utilized in voice communications mode, for example to display the identity of a calling party, the duration of a voice call, or other voice call related information.

The short-range communications subsystem enables communication between the mobile device **1000** and other proximate systems or devices, which need not necessarily be similar devices. For example, the short-range communications subsystem may include an infrared device and associated circuits and components, a Bluetooth™ communications module to provide for communication with similarly-enabled systems and devices, or a near field communications (NFC) sensor for communicating with a NFC device or NFC tag via NFC communications.

Many modifications and other embodiments will come to the mind of one skilled in the art having the benefit of the teachings presented in the foregoing descriptions and the associated drawings. Therefore, it is understood that various modifications and embodiments are intended to be included within the scope of the appended claims.

## Claims

1. A mobile wireless communications device (30) comprising:
a portable housing (31);
a printed circuit board, PCB (32) carried by said portable housing;
at least one electronic component (33a-33n) carried by said PCB and extending upwardly therefrom; and
an adhesive material layer (37') carried by said at least one electronic component;
a conformable, shape-retaining film (40) being vacuum formed onto said at least one electronic component and comprising a peripheral edge (41) secured to said PCB and a body portion (42) conforming to said at least one electronic component, and having a vacuum port opening (45') therein adjacent said adhesive material layer, the conformable, shape-retaining film being vacuum formed so as to contact said adhesive material layer at said vacuum port opening to thus seal said vacuum port opening.

2. The mobile wireless communications device of Claim 1, wherein said conformable, shape-retaining film comprises an electrically conductive layer (43) to provide Radio Frequency, RF shielding.

3. The mobile wireless communications device of Claim 2, wherein said electrically conductive layer comprises aluminum.

4. The mobile wireless communications device of Claim 2, wherein said conformable, shape-retaining film further comprises a dielectric layer (44) adjacent said electrically conductive layer.

5. The mobile wireless communications device of Claim 1, further comprising a frame (36) coupled to said PCB around said circuitry and secured to the peripheral edge of said conformable, shape-retaining film.

6. The mobile wireless communications device of Claim 1, further comprising at least one other electronic component beneath said shape-retaining film.

7. The mobile wireless communications device of Claim 1, further comprising:
a wireless transceiver (34) carried by said PCB; and
an antenna (35) coupled to said wireless transceiver.

8. The mobile wireless communications device of Claim 1, wherein said at least one electronic component comprises at least one integrated circuit (IC).

9. A method of making a mobile wireless communications device (30) comprising a portable housing (31), a printed circuit board, PCB (32) carried by the portable housing, and at least one electronic component (33a-33n) carried by the PCB and extending upwardly therefrom, the method comprising:
positioning an adhesive material layer (37') on the at least one electronic component;
vacuum forming a conformable, shape-retaining film (40) onto the at least one electronic component via a vacuum port opening (45') therein adjacent the adhesive material layer, the conformable, shape-retaining film having a peripheral edge secured to the PCB and a body portion (42) conforming to the at least one electronic component, the conformable, shape-retaining film being vacuum formed so that the conformable, shape-retaining film contacts the adhesive material layer at the vacuum port opening to thus seal the vacuum port opening.

10. The method of Claim 9, wherein the conformable, shape-retaining film comprises an electrically conductive layer (43) to provide Radio Frequency, RF shielding.

11. The method of Claim 10, wherein the conformable, shape-retaining film further comprises a dielectric layer (44) adjacent the electrically conductive layer.

12. The method of Claim 9, further comprising coupling a frame (36) to the PCB around the circuitry to secure the peripheral edge of the conformable, shape-retaining film to the PCB.

## Patentansprüche

1. Tragbare drahtlose Kommunikationsvorrichtung (30), aufweisend:
ein tragbares Gehäuse (31);
eine Leiterplatte, PCB (32), die von dem besagten tragbaren Gehäuse getragen wird;
zumindest ein elektronisches Bauteil (33a-33n), das von der besagten Leiterplatte getragen wird und sich von dieser nach oben hin erstreckt; und
eine Anhaftungsmaterialschicht (37'), die von besagtem zumindest einem elektronischen Bauteil getragen wird;
wobei ein anpassbarer, formbeständiger Film (40) auf das besagte zumindest eine elektronische Bauteil vakuumgeformt ist und eine Außenkante (41), die an der besagten Leiterplatte (PCB) befestigt ist, und einen Körperabschnitt (42), der zu diesem zumindest einen elektronischen Bauteil passt, aufweist, und mit einer Vakuumanschlussöffnung (45') darin neben der besagten Anhaftungsmaterialschicht, wobei der anpassbare, formbeständige Film vakuumgeformt ist, um die besagte Anhaftungsmaterialschicht an besagter Vakuumanschlussöffnung zu kontaktieren, um auf diese Weise die Vakuumanschlussöffnung abzudichten.

2. Tragbare drahtlose Kommunikationsvorrichtung nach Anspruch 1, wobei der besagte anpassbare, formbeständige Film eine elektrisch leitende Schicht (43) aufweist, um eine Funkfrequenz-Abschirmung bereitzustellen.

3. Tragbare drahtlose Kommunikationsvorrichtung nach Anspruch 2, wobei die besagte elektrisch leitende Schicht Aluminium aufweist.

4. Tragbare drahtlose Kommunikationsvorrichtung nach Anspruch 2, wobei der besagte anpassbare, formbeständige Film ferner eine dielektrische Schicht (44) neben dieser elektrisch leitenden Schicht aufweist.

5. Tragbare, drahtlose Kommunikationsvorrichtung nach Anspruch 1, ferner aufweisend einen Rahmen (36), der an die besagte Leiterplatte (PCB) um die besagten Schaltungen herum gekoppelt ist und an der Außenkante des besagten anpassbaren, formbeständigen Films befestigt ist.

6. Tragbare, drahtlose Kommunikationsvorrichtung nach Anspruch 1, ferner aufweisend zumindest ein anderes elektronisches Bauteil unter dem besagten formbeständigen Film.

7. Tragbare, drahtlose Kommunikationsvorrichtung nach Anspruch 1, ferner aufweisend:
einen drahtlosen Sendeempfänger (34), der von der besagten Leiterplatte (PCB) getragen wird; und
eine Antenne (35), die an den besagten Sendeempfänger gekoppelt ist.

8. Tragbare, drahtlose Kommunikationsvorrichtung nach Anspruch 1, wobei das zumindest eine elektronische Bauteil zumindest einen integrierten Schaltkreis (IC) aufweist.

9. Verfahren zur Herstellung einer tragbaren, drahtlosen Kommunikationsvorrichtung (30) aufweisend ein tragbares Gehäuse (31), eine Leiterplatte (PCB) (32), die von dem tragbaren Gehäuse getragen wird, und zumindest ein elektronisches Bauteil (33a-33n), das von der Leiterplatte (PCB) getragen wird und sich von dieser nach oben erstreckt, das Verfahren mit den Schritten:
Positionieren einer Anhaftungsmaterialschicht (37') auf dem zumindest einen elektronischen Bauteil;
Vakuumformen eines anpassbaren, formbeständigen Films (40) auf das zumindest eine elektronische Bauteil über eine Vakuumanschlussöffnung (45') darin neben der Anhaftungsmaterialschicht, wobei der anpassbare, formbeständige Film eine Außenkante, die an der Leiterplatte (PCB) befestigt ist, und einen Körperabschnitt (42), der zu dem zumindest einen elektronischen Bauteil passt, aufweist, wobei der anpassbare formbeständige Film vakuumgeformt wird, so dass der anpassbare, formbeständige Film die Anhaftungsmaterialschicht an der Vakuumanschlussöffnung kontaktiert, um auf diese Weise die Vakuumanschlussöffnung abzudichten.

10. Verfahren nach Anspruch 9, wobei der anpassbare, formbeständige Film eine elektrisch leitende Schicht (43) aufweist, um eine Funkfrequenzabschirmung bereitzustellen.

11. Verfahren nach Anspruch 10, wobei der anpassbare, formbeständige Film ferner eine dielektrische Schicht (44) neben der elektrisch leitenden Schicht aufweist.

12. Verfahren nach Anspruch 9, ferner umfassend das Koppeln eines Rahmens (36) an die Leiterplatte (PCB) um die Schaltungen herum, um die Außenkante des anpassbaren, formbeständigen Films an der Leiterplatte (PCB) zu befestigen.

## Revendications

1. Dispositif de communication mobile sans fil (30) comprenant :
un boîtier portatif (31) ;
une carte de circuits imprimés (32) portée par ledit boîtier portatif ;
au moins un composant électronique (33a à 33n) porté par ladite carte de circuits imprimés et s'étendant vers le haut à partir de celle-ci ; et
une couche de matériau adhésif (37') portée par ledit au moins un composant électronique ;
un film malléable à mémoire de forme (40) étant formé par mise sous vide sur ledit au moins un composant électronique et comprenant une arête périphérique (41) fixée sur ladite carte de circuits imprimés et une partie de corps (42), qui se conforme audit au moins un composant électronique, et possédant une ouverture de mise sous vide (45') qui y est ménagée, adjacente à ladite couche de matériau adhésif, le film malléable à mémoire de forme étant formé par mise sous vide de manière à entrer en contact avec ladite couche de matériau adhésif au niveau de ladite ouverture de mise sous vide, ce qui obture ladite ouverture de mise sous vide.

2. Dispositif de communication mobile sans fil selon la revendication 1, dans lequel ledit film malléable à mémoire de forme comprend une couche électriquement conductrice (43) pour réaliser un blindage contre les radiofréquences.

3. Dispositif de communication mobile sans fil selon la revendication 2, dans lequel ladite couche électriquement conductrice consiste en aluminium.

4. Dispositif de communication mobile sans fil selon la revendication 2, dans lequel ledit film malléable à mémoire de forme comprend en outre une couche diélectrique (44) adjacente à ladite couche électriquement conductrice.

5. Dispositif de communication mobile sans fil selon la revendication 1, comprenant en outre un cadre (36) couplé à ladite carte de circuits imprimés autour de ladite circuiterie et fixé sur l'arête périphérique dudit film malléable à mémoire de forme.

6. Dispositif de communication mobile sans fil selon la revendication 1, comprenant en outre au moins un autre composant électronique au-dessous dudit film à mémoire de forme.

7. Dispositif de communication mobile sans fil selon la revendication 1, comprenant en outre :
un émetteur-récepteur sans fil (34) porté par ladite carte de circuits imprimés ; et
une antenne (35) couplée audit émetteur-récepteur sans fil.

8. Dispositif de communication mobile sans fil selon la revendication 1, dans lequel ledit au moins un composant électronique comprend au moins un circuit intégré.

9. Procédé de fabrication d'un dispositif de communication mobile sans fil (30) comprenant un boîtier portatif (31), une carte de circuits imprimés (32) portée par ledit boîtier portatif et au moins un composant électronique (33a à 33n) porté par ladite carte de circuits imprimés et s'étendant vers le haut à partir de celle-ci, le procédé comprenant les étapes consistant à :
positionner une couche de matériau adhésif (37') sur ledit au moins un composant électronique ;
former sous vide un film malléable à mémoire de forme (40) sur ledit au moins un composant électronique, via une ouverture de mise sous vide (45') qui y est ménagée, adjacente à ladite couche de matériau adhésif, le film malléable à mémoire de forme possédant une arête périphérique fixée sur la carte de circuits imprimés et une partie de corps (42) qui se conforme audit au moins un composant électronique, le film malléable à mémoire de forme étant formé par mise sous vide de manière que le film malléable à mémoire de forme entre en contact avec ladite couche de matériau adhésif au niveau de ladite ouverture de mise sous vide, ce qui obture ladite ouverture de mise sous vide.

10. Procédé selon la revendication 9, dans lequel le film malléable à mémoire de forme comprend une couche électriquement conductrice (43) pour réaliser un blindage contre les radiofréquences.

11. Procédé selon la revendication 10, dans lequel le film malléable à mémoire de forme comprend en outre une couche diélectrique (44) adjacente à ladite couche électriquement conductrice.

12. Procédé selon la revendication 9, comprenant en outre l'étape consistant à coupler un cadre (36) à la carte de circuits imprimés autour de la circuiterie, de manière à fixer l'arête périphérique du film malléable à mémoire de forme.
